# EUROPEAN PATENT SPECIFICATION

(11) **EP 3 495 927 B1**
(45) Date of publication and mention of the grant of the patent: **22.04.2020**
(21) Application number: 16911595.3
(22) Date of filing: 02.08.2016
(51) Int. Cl.: G06F 3/041, G06F 3/045

(54) **TOUCH PANEL**
BERÜHRUNGSEMPFINDLICHES BEDIENFELD
PANNEAU TACTILE

(43) Date of publication of application: 12.06.2019
(73) Proprietor: Mitsubishi Electric Corporation, Chiyoda-ku Tokyo 100-8310 (JP)
(72) Inventor: NAKAJIMA Yoshinori, Tokyo 100-8310 (JP); KOIZUMI Yoshiaki, Tokyo 100-8310 (JP); KUROKAWA Soichiro, Tokyo 100-8310 (JP)
(74) Representative: Pfenning, Meinig & Partner mbB
(86) International application number: PCT/JP2016/072692
(87) International publication number: WO 2018/025334

(56) References cited:
- WO-A1-2015/140928
- WO-A1-2015/141058
- JP-A- H10 188 728
- JP-A- 2015 153 482
- US-A1- 2012 182 249

## Description

### Technical Field

The present disclosure relates to a touch panel.

### Background Art

Touch panels are commonly used as input devices for various types of equipment such as home electric appliances and portable terminals. Patent Literature 1, for example, discloses a resistive touch panel including transparent electrode substrates having transparent conductive films of indium tin oxide (ITO) or the like, with the transparent electrode substrates vertically opposing each other via a gap therebetween and fixed at outer frame portions thereof. As disclosed in Patent Literature 1, pressing-down positions on such a resistive touch panel, for example of a four-wire type, are detected with two parallel wires disposed on each of upper and lower substrates to alternately form a potential distribution in an X direction in one of the substrates and a potential distribution in a Y direction in the other of the substrates so that application of the potential distribution and detection of the electric potential are alternately performed on each of the upper and lower substrates. Further, a touch panel is disclosed in Patent Literature 2 in which a first sheet and a second sheet are disposed opposing each other with a gap therebetween. For the touch panel described in Patent Literature 2, the pressing-down position is detected by a simple structure in which a first conductive path is arranged on the first sheet, for example, and a second conductive path and a pressure-detecting conductive path are arranged on the second sheet. Patent Literature 3 describes a touch panel consisting of two sheets, an upper and a lower sheet with a gap in between. Opposite to the first electrode on the first sheet, two electrodes are mounted on the inner surface of the second sheet in parallel. When a pressed force is applied to the first sheet, an upper pressure sensitive ink member, covering the upper electrode, comes in contact with both of the electrodes on the second sheet and conducts them. This enables the detection of the external force applied to the pressure sensitive ink member.

### Citation List

### Patent Literature

Patent Literature 1: Unexamined Japanese Patent Application Kokai Publication No. 2012-221006
Patent Literature 2: International Publication No. WO2015/140928 A
Patent Literature 3: US-A-2012/0182249

### Summary of Invention

### Technical Problem

In the touch panel described in Patent Literature 1, a transparent conductive film (ITO) is provided for each of the upper and lower transparent electrode substrates, and two parallel wires are further provided for each of the upper and lower transparent electrode substrates. Thus configuration of the touch panel is complex.

Further, in the touch panel described in Patent Literature 1, a potential distribution is alternatingly formed in the parallel wires of the upper and lower substrates to detect the depression position. Thus the structure for detecting the depression position often becomes complex.

When using the touch panel described in Patent Literature 2, the pressing-down position is detected by causing contact between a portion of the conductive paths, such as contact between the first conductive path and the pressure-detecting conductive path. Thus the configuration of the touch panel described in Patent Literature 2 is not as complex as that of the touch panel described in Patent Literature 1, and cost of mass production is reduced. However, as described below, the touch panel described in Patent Literature 2 has a problem in that, in accordance with circumstances such as stiffness or strength of the first and second sheets and bending during pressing, the touch panel basically reacts to pressing only in the vicinity of the conductive path, thereby preventing arrangement of a switch range (range in which pressing causes reaction of a switch) of freely-selected size.

The below described results were obtained when a prototype of the touch panel described in Patent Literature 2 was produced and tested, Specifically, in the case of the touch panel described in Patent Literature 2, sometimes the switch did not react even when a location was pressed that was at least 5 mm separated from the conductive path (first conductive path, second conductive path, pressure-detecting conductive path, or pressure-detecting supplementary conductive path). That is, although there is lot-to-lot variance, the touch panel described in Patent Literature 2 is limited to a switch range of about 5 mm. The switch range of the touch panel of a typical home electric appliance or remote controller is about 10 mm, and thus the switch range of the touch panel described in Patent Literature 2 is understood to be narrower than a typical switch range.

In consideration of the aforementioned circumstances, an objective of the present disclosure is to provide a touch panel capable of expanding the switching range in which the switch reacts due to pressing, and capable of detecting the pressed switch range by a simple configuration.

### Solution to Problem

This problem is solved by a touch panel according to claim 1. Further improvements of the touch panel according to the invention are provided in the dependent claim.

### Brief Description of Drawings

FIG. 1 is a front view of a remote controller according to Example 1 of the present disclosure;
FIG. 2 is an exploded perspective view of the touch panel according to Example 1;
FIG. 3 is a front view of the touch panel according to Example 1;
FIG. 4 is a rear perspective view of internal structure of the remote controller according to Example 1;
FIG. 5 illustrates functions of a microcomputer with which the remote controller according to Example 1 is equipped;
FIG. 6 is a drawing illustrating an example of control content data according to Example 1;
FIG. 7 is a drawing illustrating an example of control processing executed by the remote controller according to Example 1;
FIG. 8 is a cross-sectional view taken along a B-B cross section in an A-A portion of FIG. 3, illustrating a state in which a structure is not depressed;
FIG. 9 is a cross-sectional view taken along the B-B cross section in the A-A portion of FIG. 3, illustrating a state in which the structure is depressed;
FIG. 10 is a drawing illustrating an example of an electrical circuit formed, due to pressing of the structure as illustrated in FIG. 9, by the first conductive path, the second conductive path, and the pressure-detecting conductive path;
FIG. 11 is a drawing illustrating an example of an image changed by pressing of the structure as illustrated in FIG. 9;
FIG. 12 shows drawings illustrating an example of processing to arrange a first conductive path and the spacer on a first sheet according to Example 1;
FIG. 13 shows drawings illustrating an example of processing to arrange a second conductive path and a pressure-detecting conductive path on the second sheet according to Example 1;
FIG. 14 is a drawing illustrating an example of processing to arrange structures on the second sheet according to Example 1;
FIG. 15 is a cross-sectional view illustrating the state in which the structure is not pressed in a case in which the second conductive path and the pressure-detecting conductive path are provided on the first sheet and the first conductive path and the structure are provided on the second sheet;
FIG. 16 is a cross-sectional view illustrating the state in which the structure is pressed in the case in which the second conductive path and the pressure-detecting conductive path are provided on the first sheet and the first conductive path and the structure are provided on the second sheet;
FIG. 17 is a front view of a touch panel according to Example 2 of the present disclosure;
FIG. 18 is a cross-sectional view illustrating a state in which a structure of a touch panel according to Example 3 of the present disclosure is not pressed;
FIG. 19 is a cross-sectional view illustrating a state in which the structure of the touch panel according to Example 3 of the present disclosure is pressed;
FIG. 20 is a cross-sectional view illustrating a state in which a structure of a touch panel according to Example 4 of the present disclosure is not pressed;
FIG. 21 is a cross-sectional view illustrating a state in which the structure of the touch panel according to Example 4 of the present disclosure is depressed;
FIG. 22 is a cross-sectional view illustrating a state in which a structure of a touch panel according to Example 5 of the present disclosure is not pressed;
FIG. 23 is a cross-sectional view illustrating a state in which the structure of the touch panel according to Example 5 of the present disclosure is pressed;
FIG. 24 is a cross-sectional view for description of configuration of another touch panel of Example 5 of the present disclosure;
FIG. 25 is a cross-sectional view for description of configuration of a touch panel of an embodiment of the present invention; and
FIG. 26 is a front view for description of configuration of the touch panel of the embodiment of the present invention.

### Description of Embodiments

Examples of the present disclosure are described below in detail with reference to drawings. Throughout the drawings, components that are the same or equivalent are assigned the same reference signs. In the drawings, fine dashed lines indicate hidden lines, and fine double-dot-dashed lines indicate virtual lines.

### Example 1

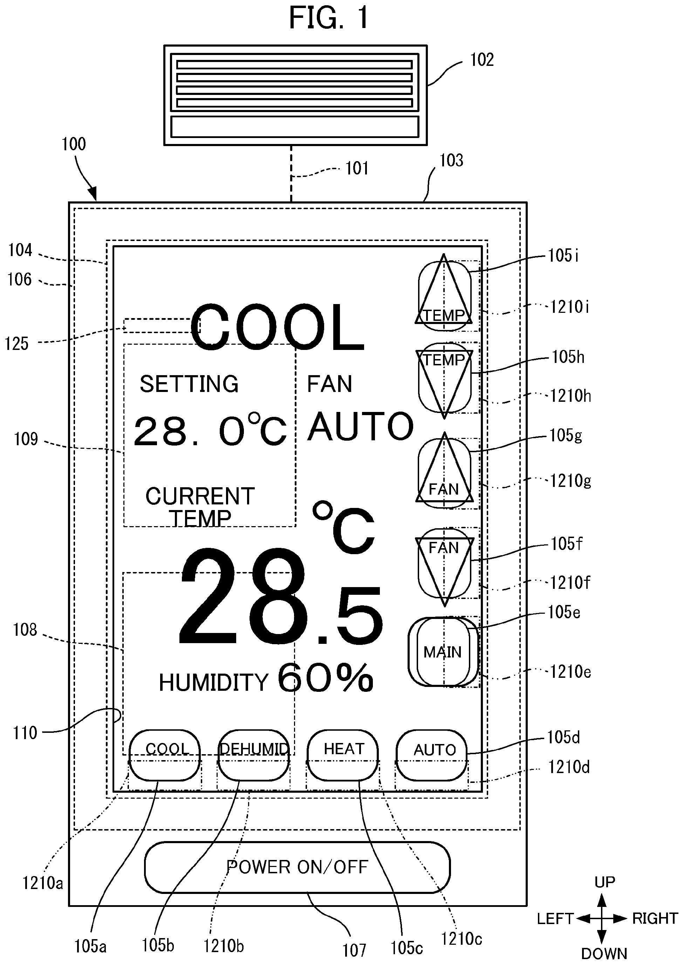

A remote controller 100 according to Example 1 of the present disclosure is a device that controls an air conditioner 102 by communication with the air conditioner 102 via a communication line 101 as shown in the front view illustrated in FIG. 1. The communication line 101 may be wireless, wired, or a combination of such, and may use a freely-selected communication protocol.

As illustrated in FIG. 1, the remote controller 100 includes: a cover 103 that accommodates therein various types of components, a display 104 for forward display of an image, a touch panel 106 that includes structures 105a to 105i that are depressed by a user, a power supply button 107 for ON-OFF switching of the air conditioner 102, a power supply 108 that supplies power for operating the remote controller 100, and a microcomputer 109 that controls operation of the remote controller 100. Further, although the structures 105a to 105i are typically pressed by a finger of the user, a pen-shaped tool may be used for pressing.

Here, the "forward direction" is taken to be the forward direction out of the plane of the paper of FIG. 1, and the "rearward direction" is taken to be toward the back of the plane of the paper.

The cover 103 in a forward direction portion thereof has an approximately rectangular-shaped opening 110. The image of the display 104 is presented in the forward direction through the opening 110 that undergoes the operation performed on the touch panel 106 by the user.

The display 104 has a screen that displays the image and a frame at the circumference of the screen. As illustrated in FIG. 1, the screen of the display 104 is typically rectangular, and is disposed to be aligned with the opening 110 of the cover 103. The display 104, for example, is a full-dot color liquid crystal display panel and includes components such as a liquid crystal panel, a drive circuit for driving the liquid crystal panel, a color filter, and a light source. A freely-selected display panel may be used for the display 104, and examples of the display panel include a monochrome liquid crystal display panel and a segmented-type liquid crystal display panel

The structures 105a to 105i are used to enable operation of the touch panel 106 in wider ranges than minimum pressure-sensitive regions 1210a to 1210i. The "minimum pressure-sensitive regions 1210a to 1210i" are ranges that are capable of pressure-sensitive reaction in the case of omission of the structures 105a to 105i, and are narrower than the switch range (range in which the switch responds to pressing) to be achieved by the touch panel 106. Thus the structures 105a to 105i are disposed on the surface of the touch panel 106, and as described below, the switch range is widened to the size of the structures 105a to 105i that are wider than the minimum pressure-sensitive regions 1210a to 1210i.

The structures 105a to 105i, for example, are transparent thin members (pads) and are formed from a material that is harder or stiffer than either a below-described first sheet 111 or a below-described second sheet 112 of the touch panel 106. Thus upon application of a force to the structure 105a by an action such as touching or pressing, the structure 105a can uniformly sink downward and transmit the pressing to the minimum pressure-sensitive region 1210a. That is, in comparison to the case in which the minimum pressure-sensitive regions 1210a to 1210i are directly pressed, by causing pressing via the structures 105a to 105i, the range in which detection of pressing is enabled can expand to the switch range that is to be achieved. Thus the operation performed on the touch panel 106 can be appropriately detected.

The touch panel 106 is a sheet-like component arranged forward of the screen of the display 104. As illustrated in FIG. 1, images displayed by the display 104 are shown at positions that overlap the structures 105a to 105i, and the images indicate processing that is executed when the respective structures 105a to 105i are depressed. Such configuration enables intuitive operation by the user.

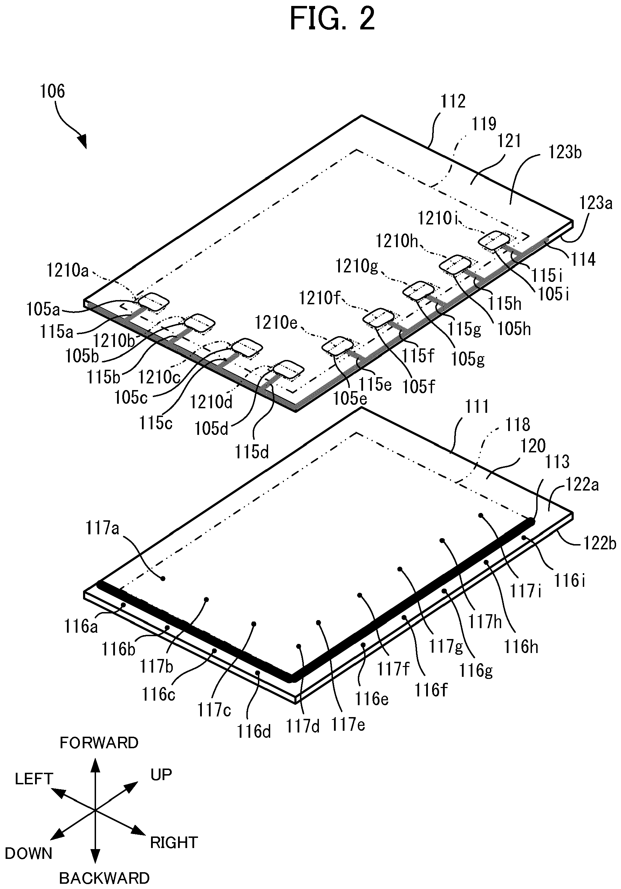

In particular, as illustrated in the exploded perspective view of FIG. 2, the touch panel 106 includes: the first sheet 111 and the second sheet 112 disposed opposing each other with a gap therebetween, a first conductive path 113 formed on the first sheet 111, a second conductive path 114 formed on the second sheet 112, pressure-detecting conductive paths 115a to 115i for detection of whether any of the structures 105a to 105i are depressed, and spacers 116a to 116i and 117a to 117i arranged between the first sheet 111 and the second sheet 112 to maintain the gap therebetween.

Further, the first sheet 111 and the second sheet 112 are disposed opposing each other in the forward-rearward direction, and thus the normal direction of the first sheet 111 is the forward-rearward direction, and the normal direction of the second sheet 112 is aligned in the same direction. That is, the expression "as viewed from the front" in the description of the present embodiments corresponds to the expression "as viewed in the normal direction of the first sheet 111".

The first sheet 111 and the second sheet 112 are each made of a material such as polyethylene terephthalate (PET) resin, and are sheet-like components that are transparent and thin or are extremely thin. In the present example, both the first sheet 111 and the second sheet 112 are rectangular shaped and have the same size as viewed from the front.

The first sheet 111 and the second sheet 112 include respective image transmission regions 118 and 119 previously determined as areas where the screen of the display 104 is positioned to be associated with the image transmission regions 118 and 119, and respective surrounding areas 120 and 121 outside the image transmission regions 118 and 119. In the present example, the image transmission region 118 and the image transmission region 119 have the same size rectangular shape as viewed from the front direction.

More specifically, the first sheet 111 includes two main surfaces (a first main surface 122a and a third main surface 122b) that form the front and rear sides of the first sheet 111. In a similar manner, the second sheet 112 includes two main surfaces (a second main surface 123a and a fourth main surface 123b) that form the front and rear sides of the second sheet 112. The first sheet 111 and the second sheet 112 are disposed so as to oppose each other in the frontward-backward direction, and thus the first main surface 122a of the first sheet 111 becomes the inner surface opposing the second sheet 112, and the third main surface 122b becomes the outer surface that does not oppose the second sheet 112. In a similar manner, the second main surface 123a of the second sheet 112 becomes the inner surface opposing the first sheet 111, and the fourth main surface 123b becomes the outer surface that does not oppose the first sheet 111.

The first main surface 122a and the second main surface 123a are disposed to oppose each other so that the image transmission region 118 of the first sheet 111 and the image transmission region 119 of the second sheet 112 overlap each other in the frontward-backward direction. In the present example, the screen of the display 104 is disposed rearward of the third main surface 122b. The image displayed on the display 104 is thus presented forward by transmission sequentially through the image transmission regions 118 and 119.

Further, as illustrated in FIG. 2, on the fourth main surface 123b (that is, the outer surface of the second sheet 112) as the front surface of the remote controller 100, the structures 105a to 105i are disposed within the image transmission region 119 and along the outer edge of the image transmission region 119. In the present example, the structures 105a to 105i are arranged, as illustrated in the same drawing, in a row extending along the lower side and the right side of the image transmission region 119.

The first conductive path 113 is an electrically conductive portion formed on the first main surface 122a (that is, the inner surface of the first sheet 111) and extending continuously in linear or strip-like form. The first conductive path 113 in the present example is a main conductive path of the first sheet 111 and is arranged on the outer edge of the image transmission region 118 of the first sheet 111. More specifically, the first conductive path 113 is provided on the lower side and the right side that make up a portion of the outer edge of the image transmission region 118.

The second conductive path 114 is an electrically conductive portion formed on the second main surface 123a (that is, the inner surface of the second sheet 112) and extending continuously in linear or strip-like form. The second conductive path 114 in the present example is a main conductive path of the second sheet 112 and is provided in the surrounding area 121 of the second main surface 123a, as illustrated in FIG. 2.

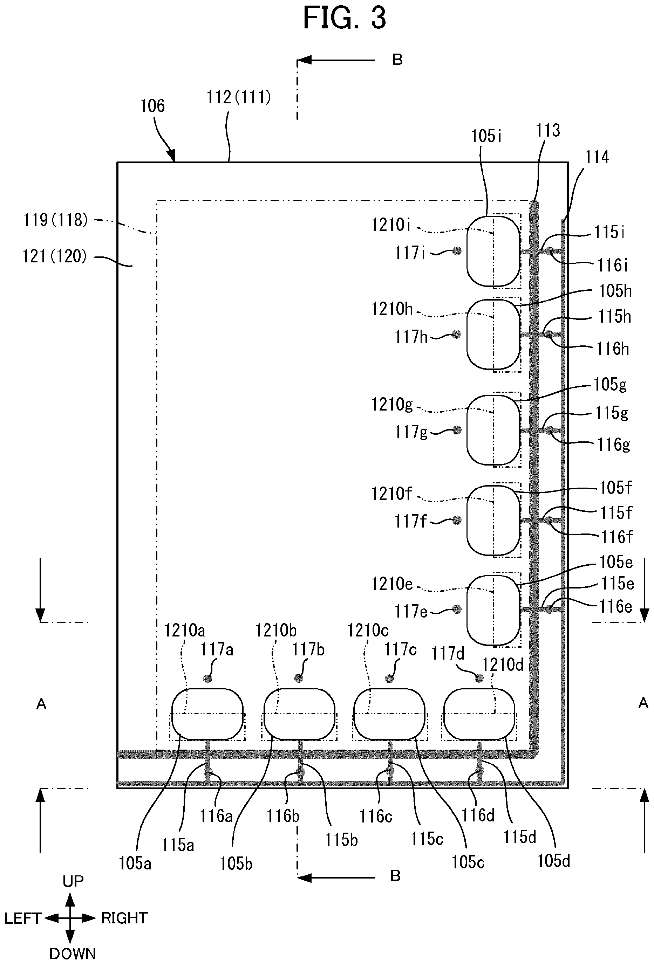

More specifically, as illustrated in FIG. 3, which is a front view of the touch panel 106, the second conductive path 114 is provided in a lower portion of the surrounding area 121, which is located below the image transmission region 119 and parallel to the lower side of the outer edge of the image transmission region 119, and is provided in a right portion of the surrounding area 121, which is located to the right of and parallel to the right side of the outer edge of the image transmission region 119. Thus, as viewed from the front direction, the second conductive path 114 is further spaced apart from the image transmission regions 118 and 119 than the first conductive path 113. Further, the first conductive path 113 and the second conductive path 114 are parallel to each other as viewed from the front direction.

Here, the first conductive path 113 and the second conductive path 114 being parallel to each other means that a distance between the first conductive path 113 and the second conductive path 114 is substantially constant in a direction perpendicular to the direction parallel to the outer edge of the image transmission regions 118 and 119 as viewed from the front.

The pressure-detecting conductive paths 115a to 115i are electrically conductive portions formed on the second main surface 123a (that is, the inner surface of the second sheet 112) in linear or strip-like form in order to detect which of the structures 105a to 105i is pressed. The pressure-detecting conductive paths 115a to 115i are supplementary conductive paths that are electrically connected to the main conductive path (second conductive path 114) of the second sheet 112. The pressure-detecting conductive paths 115a to 115i are arranged respectively in association with the structures 105a to 105i.

The pressure-detecting conductive paths 115a to 115i are, as illustrated in FIG. 3, provided along the lower side and the right side of the outer edge of the image transmission regions 118 and 119, and are parallel to each other with substantially equal spacing. The pressure-detecting conductive paths 115a to 115i are each electrically connected, at one end thereof, to the second conductive path 114 at different positions, and intersect the first conductive path 113 as viewed from the front.

The first conductive path 113, the second conductive path 114, and the pressure-detecting conductive paths 115a to 115i as described above are formed from conductive ink including a material such as silver or carbon. Printing of the conductive ink enables easy formation of the first conductive path 113, the second conductive path 114, and the pressure-detecting conductive paths 115a to 115i. Further, relatively low cost of the conductive ink enables a reduction in manufacturing costs.

The spacers 116a to 116i and 117a to 117i are provided between the first sheet 111 and the second sheet 112. Each of the spacers 116a to 116i and 117a to 117i is an extremely small transparent spherical particle that is made of a material such as resin.

The spacers 116a to 116i are disposed between the first conductive path 113 and the second conductive path 114 so that the spacers 116a to 116i and the corresponding pressure-detecting conductive paths 115a to 115i overlap, as viewed from the front as illustrated in FIG. 3. The spacers 116a to 116i can maintain the gap between the pressure-detecting conductive paths 115a to 115i and the first conductive path 113. This enables reliable prevention of the pressure-detecting conductive paths 115a to 115i from making electrical contact with the first conductive path 113 in a state in which none of the structures 105a to 105i are pressed.

The spacers 117a to 117i are disposed inside the image transmission regions 118 and 119 at positions located along lines extending from the corresponding pressure-detecting conductive path of the pressure-detecting conductive paths 115a to 115i as viewed from the front as illustrated in FIG. 3. The minimum pressure-sensing regions 1210a to 1210i are each defined between the region in which the corresponding spacers 117a to 117i are arranged and the first conductive path 113 as viewed from the front.

In the state in which none of the structures 105a to 105i are pressed, the spacers 117a to 117i can keep, in the minimum pressure-sensitive regions 1210a to 1210i, a gap between the second sheet 112 and the first sheet 111 opposing each other in the front-back direction. When any of the structures 105a to 105i is pressed, the gap narrows between the second sheet 112 and the first sheet 111 at the minimum pressure-sensitive region 1210a to 1210i corresponding to the pressed structure 105a to 105i. Thus the pressure-detecting conductive paths 115a to 115i corresponding to the pressed one of the structures 105a to 105i reliably flexes together with the second sheet 112, thereby enabling an electrical contact with the first conductive path 113.

Such arrangement of the spacers 116a to 116i and 117a to 117i maintains the gap between the first sheet 111 and the second sheet 112 in the state in which the structures 105a to 105i are not pressed. The length of the gap in the front-back direction is set such that, when any of the structures 105a to 105i is pressed so that the second sheet 112 flexes, the pressure-detecting conductive path 115a to 115i corresponding to the pressed structure 105a to 105i contacts the first conductive path 113.

The power supply button 107 is a button arranged below the opening 110 in the front portion of the cover 103, as illustrated in FIG. 1. When the user depresses the power supply button 107, the air conditioner 102 is turned ON or OFF under control of the microcomputer 109.

Here, the "turning ON" of the air conditioner 102 denotes a state (operation state) in which the air conditioner 102 operates to condition the air within a target space. The "turning OFF" of the air conditioner 102 denotes a state (standby state) in which the air conditioner 102 waits for an instruction to start operation, that is, an instruction output by the microcomputer 109 upon the pressing down of the power supply button 107.

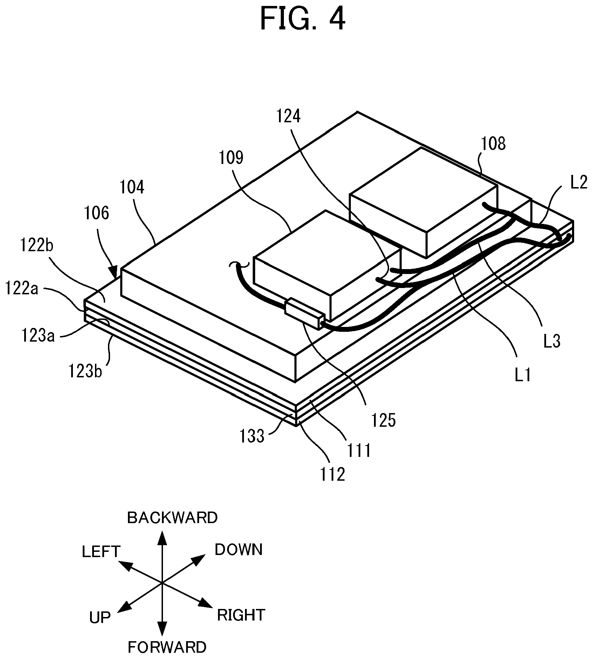

The microcomputer 109 is disposed behind the display 104, for example, as illustrated in FIG. 4, and is enclosed within the cover 103. As illustrated in the drawing, the microcomputer 109 has an analog/digital (A/D) input port 124 to which an end of the second conductive path 114 (the left end in the present example) is connected by a wire L1. The wire L1 branches off between the second conductive path 114 and the A/D input port 124 and is grounded (connected to a reference voltage) through a resistor 125.

The microcomputer 109 is a device for controlling the display 104, the air conditioner 102, and the like in accordance with input signals. Physical components of the microcomputer 109 include, for example, a processor for performing various types of arithmetic operations, a register for storing instructions, information, and the like, and a storage for storing data.

The input signals include a signal from the power supply button 107 in response to pressing thereof by the user, a signal from the touch panel 106 in response to pressing thereof by the user, a signal including environment information output from various sensors (unillustrated), and the like. The environment information may be, for example, temperature measured by a temperature sensor, humidity measured by a humidity sensor, information about human presence or absence detected by a human presence sensor, or the like.

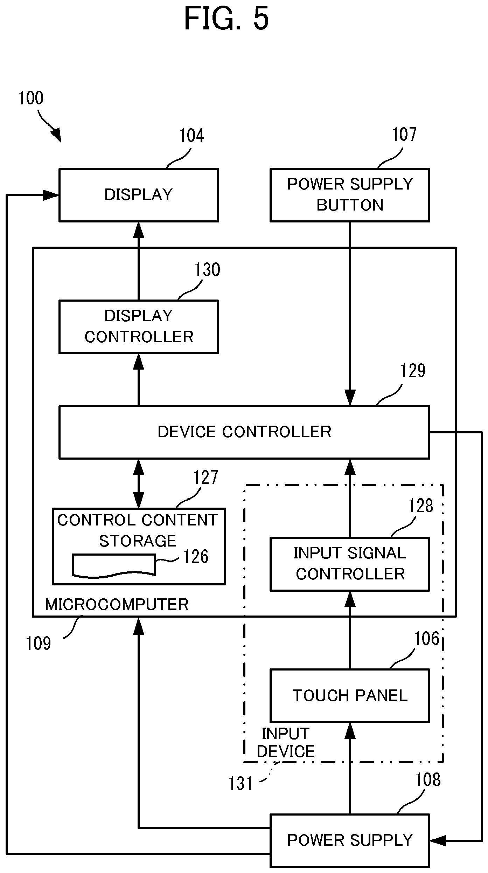

As illustrated in FIG. 5, the microcomputer 109 according to the present example functionally includes a control content storage 127 for storing beforehand therein control content data 126, an input signal controller 128 for determining, based on the input signal from the touch panel 106, which of the structures 105a to 105i is pressed, a device controller 129 for controlling the air conditioner 102 based on the pressed structure 105a to 105i, and a display controller 130 for causing display of an image on the display 104. These functions are implemented, for example, by the microcomputer 109 executing pre-loaded programs.

The control content data 126 defines control content corresponding to the pressed structure 105a to 105i. The control content includes content such as control for one or both of the air conditioner 102 and the remote controller 100. Control of the remote controller 100, for example, includes a change of an image displayed on the display 104, and the like.

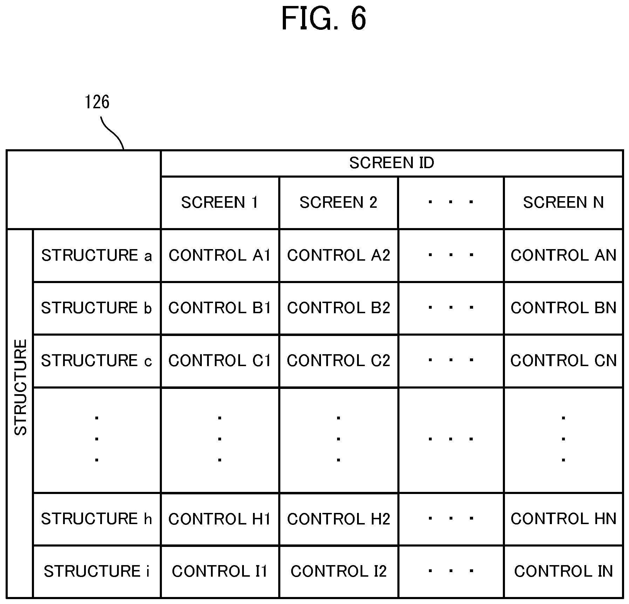

Each item of the control content data 126 according to the present example includes control content associated with a combination of the structure 105a to 105i and the screen ID, as illustrated in FIG. 6. The screen ID is information for identification of an image that is displayed on the screen of the display 104. For example, when a "structure b" is pressed while the image having a "screen ID" that is a "screen 1" is displayed, the microcomputer 109 controls one or both of the air conditioner 102 and the remote controller 100 in accordance with a "control B1".

The input signal controller 128 determines which of the structures 105a to 105i is pressed, based on a resistance value of an electric circuit formed upon the pressing of any of the structures 105a to 105i. Such an input signal controller 128, together with the touch panel 106, forms an input device 131 for accepting a user input operation to the remote controller 100.

Specifically, upon the pressing of any of the structures 105a to 105i, the corresponding minimum pressure-sensitive regions 1210a to 1210i are also pressed. Thus the first conductive path 113 makes an electrical contact with any of the pressure-detecting conductive paths 115a to 115i corresponding to the pressed structure 105a to 105i (minimum pressure-sensitive regions 1210a to 1210i). Thus an electric circuit is formed by the first conductive path 113, the second conductive path 114, and the pressure-detecting conductive paths 115a to 115i corresponding to the pressed structure 105a to 105i. The input signal controller 128 determines a resistance value of the electric circuit formed upon the pressing, based on a voltage value of the input signal that is input to the A/D input port 124. Then the input signal controller 128 determines which of the structures 105a to 105i is pressed, based on the resistance value of that electric circuit.

The device controller 129 controls one or more of the air conditioner 102, the remote controller 100, and the like, based on the structure 105a to 105i determined by the input signal controller 128 and based on the control content data 126.

The display controller 130 displays an image on the display 104 under the instruction of the device controller 129.

The microcomputer 109 installed in the remote controller 100 is not limited to a single microcomputer, and a processor for controlling the display 104 may be, for example, additionally mounted thereon. In addition to or alternatively to the storage of the microcomputer 109, a storage device such as relatively large-capacity flash memory may be mounted on the remote controller 100.

The power supply 108 is typically a device for conversion of commercial power, but may be a battery, a secondary battery, or the like. The power supply 108 may be provided in the remote controller 100 as appropriate, and for example, is provided behind the display 104 inside the cover 103, as illustrated in FIG. 4, which is a rearward direction view thereof.

The power supply 108 supplies, to the touch panel 106, direct current power for operation thereof. In the present example, as illustrated the drawing, the power supply 108 is connected to an end of the first conductive path 113 (the left end in the present example) by a wire L2. A voltage having a predetermined magnitude (for example, 5.0 V) is applied via the wire L2 to the first conductive path 113.

The power supply 108 supplies, to the microcomputer 109, direct current power for operation thereof. In the present example, as illustrated in the drawing, power from the power supply 108 is supplied to the microcomputer 109 via a wire L3, which branches off from the wire L2. Thus the microcomputer 109 is supplied with power having the same magnitude as the first conductive path 113 (for example, 5.0 V direct current power).

Since the touch panel 106 and the microcomputer 109 both operate on power supplied from the same power supply 108, the need for a separate power supply 108 for each of the touch panel 106 and the microcomputer 109 is thus eliminated. This suppresses increase in the size of the input device 131 and in turn the size of the remote controller 100.

In the present example, the voltage is applied to the first conductive path 113, and the second conductive path 114 is connected to the A/D input port 124 and grounded through the resistor 125. However, the first conductive path 113 may be connected to the A/D input port 124 and grounded through the resistor 125, and a predetermined magnitude of voltage may be applied to the second conductive path 114.

In the foregoing description, the structure of the remote controller 100 according to the present example is described. Hereinafter, the operation of the remote controller 100 according to the present example is described.

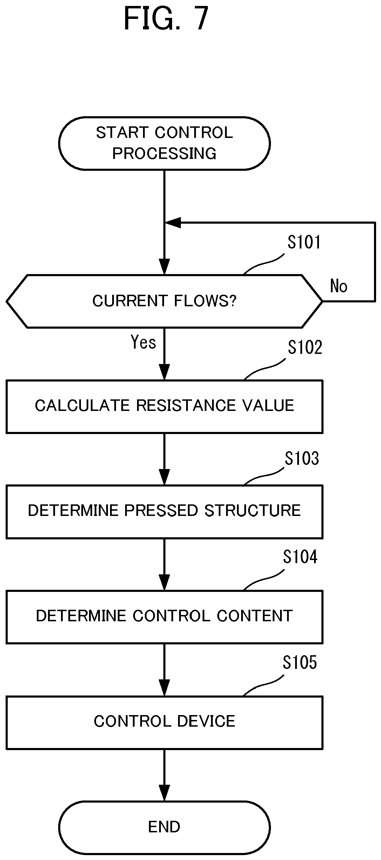

The remote controller 100, when in the operating state, executes control processing as illustrated in FIG. 7. Here, the image as illustrated in FIG. 1 is assumed to be initially displayed.

The image displayed on the remote controller 100 as illustrated in FIG. 1 indicates the following: the air conditioner 102 is operating under "SETTING: 28.0°C", "FAN: AUTO", and "COOL"(for example). The structures 105a to 105d are respectively associated with functions for switching the operation mode into the "COOL" mode, "DEHUMIDIFY" mode, "HEAT" mode, and "AUTO" mode. The structure 105e is associated with a function for switching the image to a predetermined "main" image. The structure 105f is associated with airflow switching in an order (for example, in the order of "AUTO", "HIGH", "LOW", and "VERY LOW"), and the structure 105g is associated with the airflow switching in the reverse order. The structure 105h is associated with reducing the temperature setting in predetermined decrements such as 0.5°C, and the structure 105i is associated with increasing the temperature setting in such predetermined increments.

The input signal controller 128 determines, based on an input signal to the A/D input port 124, whether current flows in the second conductive path 114 (step S101).

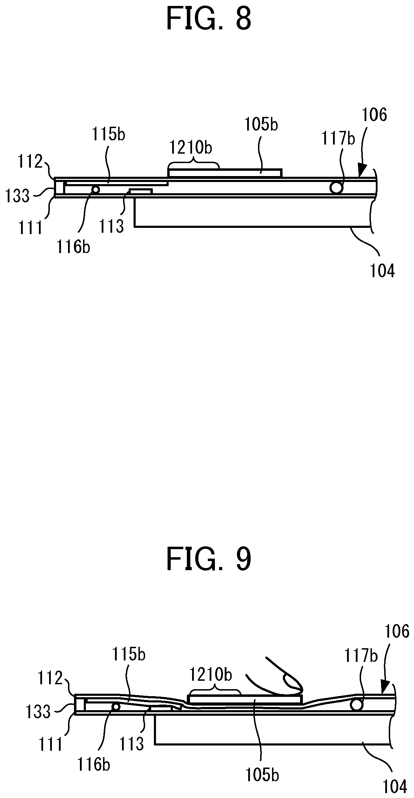

For example, as illustrated in the cross-sectional view of FIG. 8, the pressure-detecting conductive path 115b corresponding to the structure 105b is spaced apart from the first conductive path 113. In this manner, when none of the structures 105a to 105i are pressed, all the pressure-detecting conductive paths 115a to 115i are spaced apart from the first conductive path 113. Thus the pressure-detecting conductive paths 115a to 115i are insulated from the first conductive path 113 (that is, the resistance therebetween is infinite), and the current flowing in the second conductive path 114 is nearly zero.

Hence, the input signal to the A/D input port 124 is not substantially input when none of the structures 105a to 105i are pressed. That is, even if the input signal is input to the A/D input port 124, the voltage of the input signal is very weak subthreshold noise. The input signal controller 128 compares a threshold with the voltage of the input signal to the A/D input port 124, and for example, determines that no current flows in the second conductive path 114 when the voltage is equal to or less than the threshold.

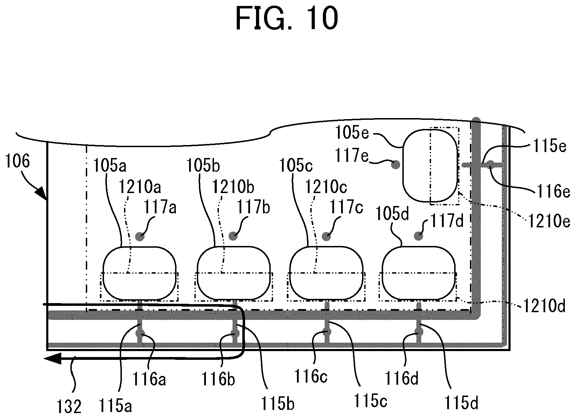

For example, as illustrated in the cross-sectional view of FIG. 9, when the structure 105b is pressed, due to high hardness or stiffness of the structure 105b, the structure 105b uniformly sinks downward even when the edge of the structure 105b is pressed, and the second sheet 112 flexes, which makes electrical connection between the first conductive path 113 and the pressure-detecting conductive path 115b associated with the structure 105b. Thus even when the minimum pressure-sensitive region 1210b is pressed, due to second sheet 112 in the vicinity thereof flexing together with the pressure-detecting conductive path 115b, the pressure-detecting conductive path 115b, and the first conductive path 113 electrically contact each other. That is, the pressed structure 105b causes flexing of the associated pressure-detecting conductive path 115b so as to be brought into electrical contact with the first conductive path 113. Thus the first conductive path 113, the pressure-detecting conductive path 115b, and the second conductive path 114 form an electric circuit to cause a current flow in the electric circuit as indicated by an arrow 132 in FIG. 10. Thus the current flows through the electric circuit formed upon the pressing of the structure 105b, and the input signal is input to the A/D input port 124.

Similarly, when any of the structures 105a and 105c to 105i is pressed, one of the pressure-detecting conductive paths 115a and 115c to 115i corresponding to the pressed structure of the structures 105a and 105c to 105i electrically connects to the first conductive path 113. An electric circuit is thereby formed by the first conductive path 113, one of the pressure-detecting conductive paths 115a and 115c to 115i corresponding to the pressed structure of the structures 105a and 105c to 105i, and the second conductive path 114. Thus the current flows through the electric circuit formed upon the pressing of any of the structures 105a and 105c to 105i, and the input signal is input to the A/D input port 124.

Thus when any of the structures 105a to 105i is pressed, the input signal is input to the A/D input port 124. The input signal controller 128 compares a threshold with the voltage of the input signal to the A/D input port 124, and for example, determines that current flows in the second conductive path 114 when the voltage is greater than the threshold.

When the input signal controller 128 determines that no current flows (NO in step S101), the input signal controller 128 continues the processing of step S101.

Upon determination that current flows (YES in step S101), the input signal controller 128 calculates a resistance value on the basis of the voltage value of the input signal to the A/D input port 124 and a magnitude of a previously applied voltage (step S102).

Specifically, as described above with reference to FIG. 4, the voltage of the predetermined magnitude is applied to the first conductive path 113 through the wire L2. The voltage applied to the first conductive path 113 is divided into a voltage across a resistance (interconnection resistance) of the electric circuit formed upon the pressing and a voltage across the resistor 125.
The resistance value of the resistor 125 may be determined as appropriate in terms of design. Thus the input signal controller 128 can calculate a resistance value of the electric circuit corresponding to the pressed structure of the structures 105a to 105i on the basis of the voltage value of the input signal to the A/D input port 124 and the voltage value applied to the first conductive path 113.

In step S102, the input signal controller 128 thus determines, for example when the structure 105b is pressed, the resistance value of the electric circuit formed upon the pressing of the structure 105b.

The input signal controller 128 determines, on the basis of the resistance value calculated in step S102, which of the structures 105a to 105i is pressed (step S103).

Here, as described above, the first conductive path 113 and the second conductive path 114 extend along the outer edges of the image transmission regions 118

and 119. Further, the voltage is applied to one end of the first conductive path 113, and the current flowing from one end of the second conductive path 114 located adjacent to the one end of the first conductive path 113 is input to the A/D input port 124 as the input signal.

When any of the structures 105a to 105i is pressed, one of the pressure-detecting conductive paths 115a to 115i corresponding to the pressed structure is electrically connected to the first conductive path 113. Thus the length of the electric circuit formed upon the pressing of any of the structures 105a to 105i varies depending on which of the structures 105a to 105i is pressed. This electric circuit is formed by the one of the pressure-detecting conductive paths 115a to 115i corresponding to the pressed structure of the structures 105a to 105i, the first conductive path 113, and the second conductive path 114.

Thus the resistance value calculated in step S102 varies depending on which of the structures 105a to 105i is pressed.

For example, the input signal controller 128 may previously store data inter-associating the structures 105a to 105i and the resistance values. The input signal controller 128 may determine the pressed structure of the structures 105a to 105i on the basis of the data and the resistance value calculated in step S102. The resistance values included in the data and associated with the respective structures 105a to 105i may be set to have a range such as a range from X1 [Ω] to X2 [Ω] since some error is tolerable.

The device controller 129 acquires data indicating one of the structure 105a to 105i determined in step S103. The device controller 129 identifies a screen ID of the image being displayed on the display 104. The screen ID of the image being displayed may be stored, for example, in the device controller 129. The device controller 129 determines the control content on the basis of the structure 105a to 105i indicated by the acquired data, the identified screen ID, and the control content data 126 (step S104).

For example, when the "screen ID" of the image illustrated in FIG. 1 is "screen 1" and the "structure b" is pressed, the device controller 129 determines the control content, that is, "control B1", by referring to the control content data illustrated in FIG. 6.

The device controller 129 controls, in accordance with the control content determined in step S104, one or more of the air conditioner 102, the remote controller 100, and the like (step S105).

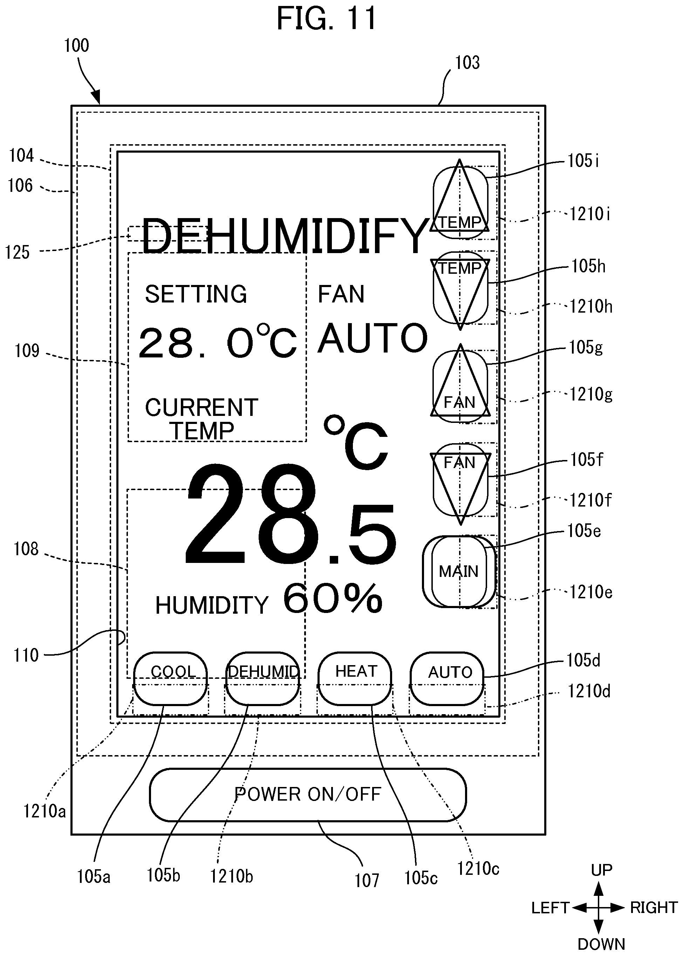

As described above in the example illustrated in FIG. 1, "structure b" is associated with a function of switching to the "DEHUMIDIFY" mode after the pressing of "structure b". Thus the device controller 129 switches the operation mode of the air conditioner 102 from the cooling mode to the dehumidification mode.
Further, the device controller 129 outputs an instruction to the display controller 130 to cause the image displayed on the display 104 to be switched to the image illustrated in FIG. 11. In response to the instruction, the display controller 130 generates image data for displaying the image illustrated in FIG. 11, and then causes the display 104 to display the image. In the image as illustrated in FIG. 11, "COOL" in FIG. 1 is replaced with "DEHUMIDIFY".

Accordingly, the remote controller 100 according to the present example enables determination of which of the structures 105a to 105i of the touch panel 106 is depressed. The air conditioner 102, the remote controller 100, and the like are controlled to cause operation depending on the which structure is pressed of the structures 105a to 105i.

In the foregoing description, the operation of the remote controller 100 according to the present example is described. Hereinafter a method for manufacturing the remote controller 100 according to the present example is described.

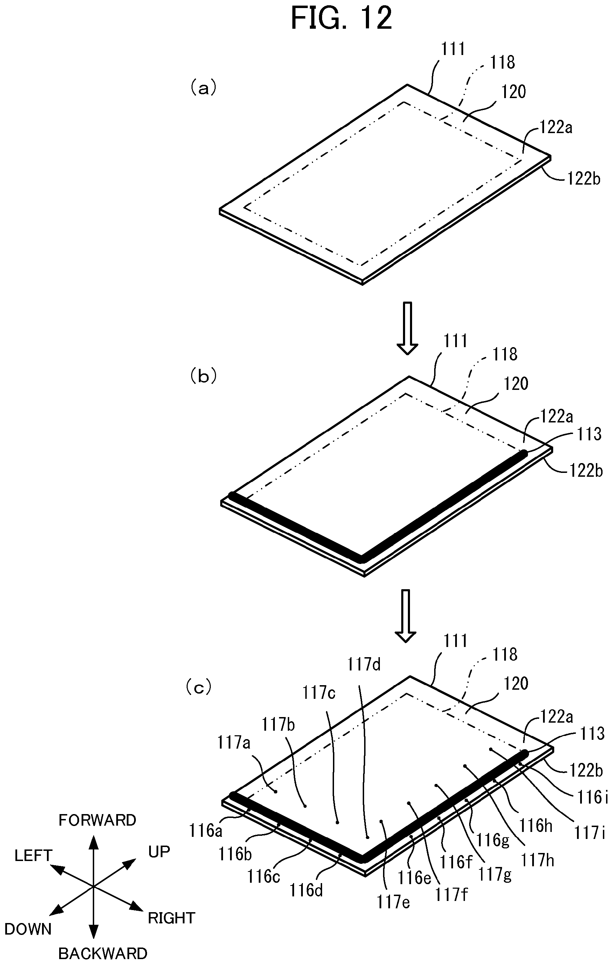

The first sheet 111 is prepared as illustrated in diagram (a) of FIG. 12.

As illustrated in diagram (b) of FIG. 12, the first conductive path 113 is arranged along the outer edge of the image transmission region 118 on the first main surface 122a of the first sheet 111. The first conductive path 113 is provided by printing of conductive ink. In the present example, the first conductive path 113 is arranged along the lower side and the right side of the image transmission region 118.

As illustrated in diagram (c) of FIG. 12, the spacers 116a to 116i and 117a to 117i are disposed on the first main surface 122a of the first sheet 111.

The spacers 116a to 116i are disposed on the respective pressure-detecting conductive paths 115a to 115i. Further, the spacers 116a to 116i are disposed between the position where the second conductive path 114 is to be disposed and the position of the first conductive path 113, as viewed from the forward direction.

One each of the spacers 117a to 117i is disposed in a corresponding region in the image transmission region 118 of the first sheet 111. Each of the regions in which the respective spacers 117a to 117i are disposed is a region located in a direction in which the pressure-detecting conductive paths 115a to 115i are each extended, as viewed from the front, with the second sheet 112 stacked on the first sheet 111.

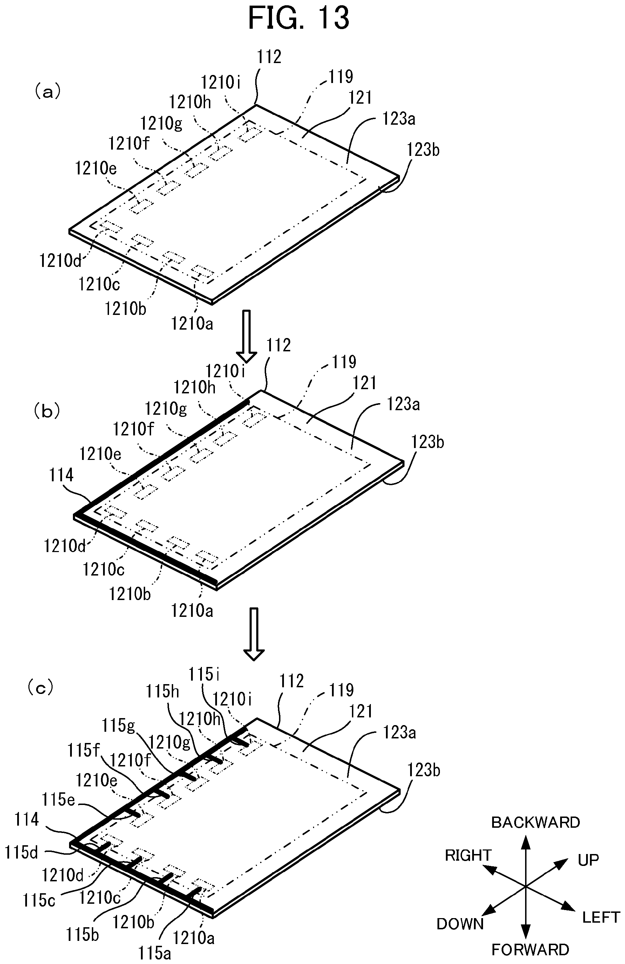

The second sheet 112 is prepared as illustrated in diagram (a) of FIG. 13.

As illustrated in diagram (b) of FIG. 13, the second conductive path 114 is disposed along the outer edge of the surrounding area 121 on the second main surface 123a of the second sheet 112. The second conductive path 114 is provided by printing of conductive ink. The second conductive path 114 is disposed in a position spaced apart from the first conductive path 113 as viewed from the front, when the first sheet 111 and the second sheet 112 made to oppose each other. In the present example, the second conductive path 114 is disposed, in the surrounding area 121 of the second sheet 112, within the surrounding area 121 of the second sheet 112, and in the lower portion of the surrounding area 121 below the lower side of the image transmission region 119 and in the right portion of the surrounding area 121 farther to the right than the right side of the image transmission region 119.

As illustrated in diagram (c) of FIG. 13, each of the pressure-detecting conductive paths 115a to 115i is disposed on the second main surface 123a of the second sheet 112. The pressure-detecting conductive paths 115a to 115i are each provided by printing of conductive ink. The pressure-detecting conductive paths 115a to 115i are each provided to be electrically connected with the second conductive path 114. The pressure-detecting conductive paths 115a to 115i are each disposed to intersect the first conductive path 113 as viewed from the forward direction with the first sheet 111 and the second sheet 112 opposing each other.

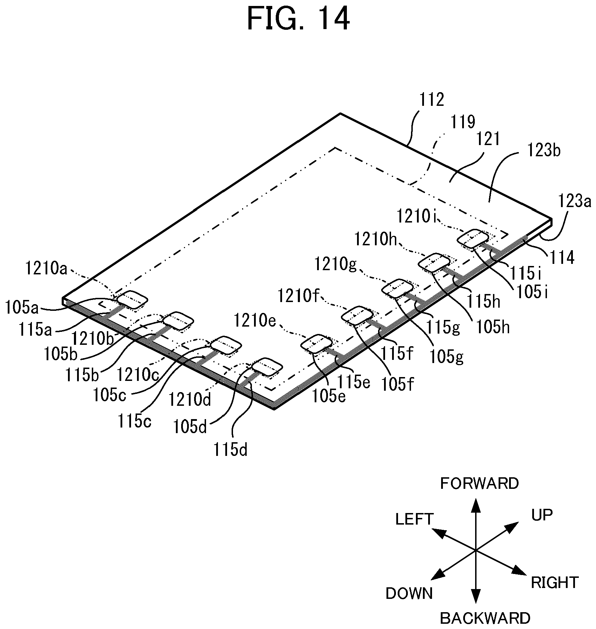

Further, as illustrated in FIG. 14, each of the structures 105a to 105i is arranged on the fourth main surface 123b of the second sheet 112. Each of the structures 105a to 105i, corresponding to the pressure-detecting conductive paths 115a to 115i, is arranged within the image transmission region 119 of the second sheet 112. For example, the structures 105a to 105i are fixed (attached) by adhesive or double-sided tape so as to partially overlap the minimum pressure-sensitive regions 1210a to 1210i.

The first sheet 111 on which the first conductive path 113 is disposed and the second sheet 112 on which the second conductive path 114 and the pressure-detecting conductive paths 115a to 115i, and the structures 105a to 105i are disposed are fixed, with the first main surface 122a and the second main surface 123a opposing each other. Here, the image transmission region 118 of the first sheet 111 and the image transmission region 119 of the second sheet 112 are disposed so as to be aligned with each other in the front-back direction. Examples of fixing techniques include use of an adhesive 133 applied to the outer edge portions of the first main surface 122a or the second main surface 123a (for example, see FIG. 8). Double-sided tape may be used for fixing attachment. The touch panel 106 according to the present example is manufactured in this manner.

As illustrated in FIG. 4, the screen of the display 104 is fixed to face the rear surface (the third main surface 122b) of the touch panel 106, and the microcomputer 109 and the power supply 108 are each fixed on the rear surface of the display 104. Screws, adhesives, double-sided tape, and the like may be used for the fixing as appropriate. The one end of the second conductive path 114 is electrically connected to the A/D input port 124 of the microcomputer 109 by the wire L1 having a branch line with the resistor 125 disposed thereon. The one end of the first conductive path 113 is connected to the power supply 108 by the wire L2.

The touch panel 106, the display 104, the microcomputer 109, the power supply 108, and the like, all of which are assembled as described above, are enclosed within the cover 103. The remote controller 100 is thereby manufactured. The end portion of the branch line of the wire L1 is grounded during installation of the remote controller 100.

According to the present example, when the structure 105a to 105i having high hardness or stiffness is pressed, the pressed structure 105a to 105i uniformly sinks downward. Thus the corresponding minimum pressure-sensitive region 1210a to 1210i is also pressed, and the surrounding second sheet 112 flexes such that electrical connection is made between the corresponding pressure-detecting conductive path 115a to 115i and the first conductive path 113. Thus there is no requirement to provide a transparent conductive film, for sensing that the structure 105a to 105i is pressed, on any of the first sheet 111 or the second sheet 112. For example, arranging the first conductive path 113 on the first sheet 111, and arranging the second conductive path 114, the pressure-detecting conductive paths 115a to 115i, and the structures 105a to 105i on the second sheet 112, are sufficient. Such arrangement enables simplification of the configuration of the touch panel 106. Further, wherever the pressed location of the structure 105a to 105i, due to the uniform force applied from the structure having high hardness or stiffness, electrical contact is possible between the first conductive path 113 and the pressure-detecting conductive path 115a to 115i, and thus the switch range can be appropriately expanded.

Further, according to the present example, when any of the structures 105a to 105i corresponding to the pressure-detecting conductive paths 115a to 115i is pressed, electrical contact is made between the first conductive path 113 and the pressure-detecting conductive path 115a to 115i corresponding to the pressed structure 105a to 105i. The electrical circuit is thus formed. Length of the electrical circuit formed by pressing differs in accordance with the pressed structure 105a to 105i. Thus merely by applying a voltage to either the first conductive path 113 or the second conductive path 114, which of the structures 105a to 105i is pressed can be determined on the basis of the resistance value of the circuit formed by pressing. This thus enables simplification of the configuration for detection of which of the structures 105a to 105i is pressed among the structures 105a to 105i.

According to the present example, applying a predetermined voltage to the first conductive path 113 is sufficient, so that switching is not required between the conductive paths 113 and 114 to which the voltage is to be applied. This simplifies the configuration for detection of the pressed structure 105a to 105i. Detection of the pressed structure 105a to 105i is thus enabled by a simple configuration.

According to the present example, the voltage of the input signal that is input to the A/D input port 124 of the microcomputer 109 is nearly equal to the voltage at the one end of the second conductive path 114. Thus, measurement of the voltage of the input signal that is input to the A/D input port 124 enables determination of which of the structures 105a to 105i is pressed. The pressed structure 105a to 105i can be detected in this manner even without an additional sensor for measuring the voltage at the one end of the second conductive path 114. This enables simplification of the configuration for detection of the pressed structure 105a to 105i. Thus detection of the pressed structure 105a to 105i is enabled using a simple configuration.

In the present example, the first conductive path 113 is disposed in parallel to the outer edge of the image transmission region 118, and the second conductive path 114 is disposed in parallel to the outer edge of the image transmission region 119. Such parallel arrangement may allow the manufacturing of the touch panel 106 by disposing pressure-detecting conductive paths 115a to 115i of a fixed length. Such configuration enables easy manufacture of the touch panel 106.

Example 1 of the present disclosure is described above, but is not limited to the description above.

For example, the target to be controlled (a control target device) by the remote controller 100 is not limited to the air conditioner 102, and may be an electric device such as, for example, a lighting device, a hot water heater, and the like. The input device 131 is not limited to the remote controller 100, and various apparatuses, devices, or the like such as electrical apparatuses and terminal devices may be used.

For example, examples of both the first sheet 111 and the second sheet 112 are described as entirely transparent sheets in the present example. However, the surrounding area 120 in the first sheet 111 and the surrounding area 121 in the second sheet 112 need not be transparent provided that at least the image transmission regions 118 and 119 are transparent. The image transmission regions 118 and 119 having a size and shape allowing transmission through at least a predetermined range of the screen of the display 104 are sufficient.

In the present example, the screen of the display 104 is located behind the third main surface 122b. However, the touch panel 106 may be arranged back-to-front in the remote controller 100 relative to the orientation of the touch panel 106 in the present example. In this case, the screen of the display 104 is located behind the fourth main surface 123b, and the third main surface 122b forms the front surface of the remote controller 100.

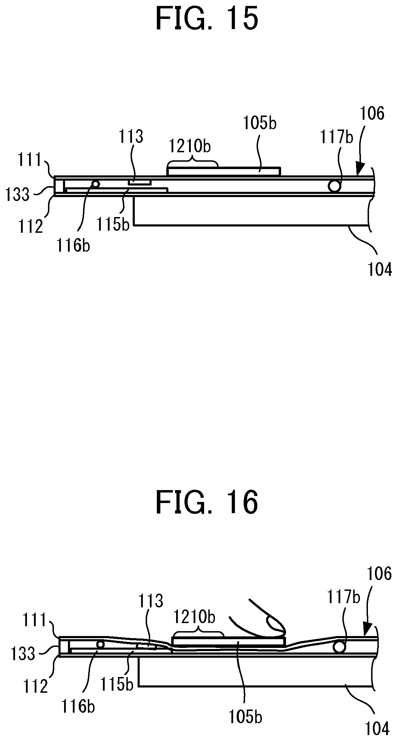

In this arrangement, as illustrated in the cross-sectional view of FIG. 15 for example, the structures 105a to 105i are arranged on the third main surface 122b of the first sheet 111, that is, on the outer surface of the first sheet 111. FIG. 15 illustrates the structure 105b as an example. The structures 105a to 105i are arranged within the image transmission region 118 of the first sheet 111 at locations corresponding to the pressure-detecting conductive paths 115a to 115i. For example, the structures 105a to 105i are fixed by adhesive or double-sided tape so as to partially overlap the minimum pressure-sensitive regions 1210a to 1210i.

Then when the structure 105b is pressed as illustrated in the cross-sectional view of FIG. 16, for example, due to high hardness or stiffness of the structure 105b, the structure 105b uniformly sinks downward even when the edge of the structure 105b is pressed. In this manner, the minimum pressure-sensitive region 1210b is also pressed, the first sheet 111 in the periphery of the pressed portion flexes together with the first conductive path 113, and thus the first conductive path 113 and the pressure-detecting conductive path 115b are electrically connected. That is, the pressed structure 105b causes flexing of the first conductive path 113 so that electrical contact is made with the associated pressure-detecting conductive path 115b. Also in this case, configuration of the touch panel 106 can be simplified, and the switch range can be appropriately expanded.

Further, for example, any or all of the first conductive path 113, the second conductive path 114, and the pressure-detecting conductive paths 115a to 115i may be formed of materials other than conductive ink, and may be a thin wire of silver, copper, and the like.

For example, the first conductive path 113 may be disposed at any position of the first main surface 122a. Disposal of the second conductive path 114 on the second main surface 123a at a position spaced apart from the first conductive path 113 as viewed from the front is sufficient. Forming the pressure-detecting conductive paths 115a to 115i on the second main surface 123a to be electrically connected with the second conductive path 114 so as to intersect the first conductive path 113 as viewed from the front is sufficient.

However, visibility to the human eye is possible if the first conductive path 113 is a line having a width of approximately 0.1 mm. Visibility of the screen may be reduced when the first conductive path 113 having such a width occupies a place in front of the screen. However, the first conductive path 113 does not occupy a place in front of the screen if the first conductive path 113 is disposed on the outer edge of the image transmission region 118 of the first sheet 111 as in the present example, or if the first conductive path 113 of the first sheet 111 is disposed in the surrounding area 120. Such configuration enables prevention of the reduction in the visibility of the screen.

In addition, similarly to the first conductive path 113, disposing the second conductive path 114 and the pressure-detecting conductive paths 115a to 115i on the outer edge or in the surrounding area 121 of the image transmission region 119 of the second sheet 112 enables prevention of the reduction in the visibility of the screen.

### Example 2

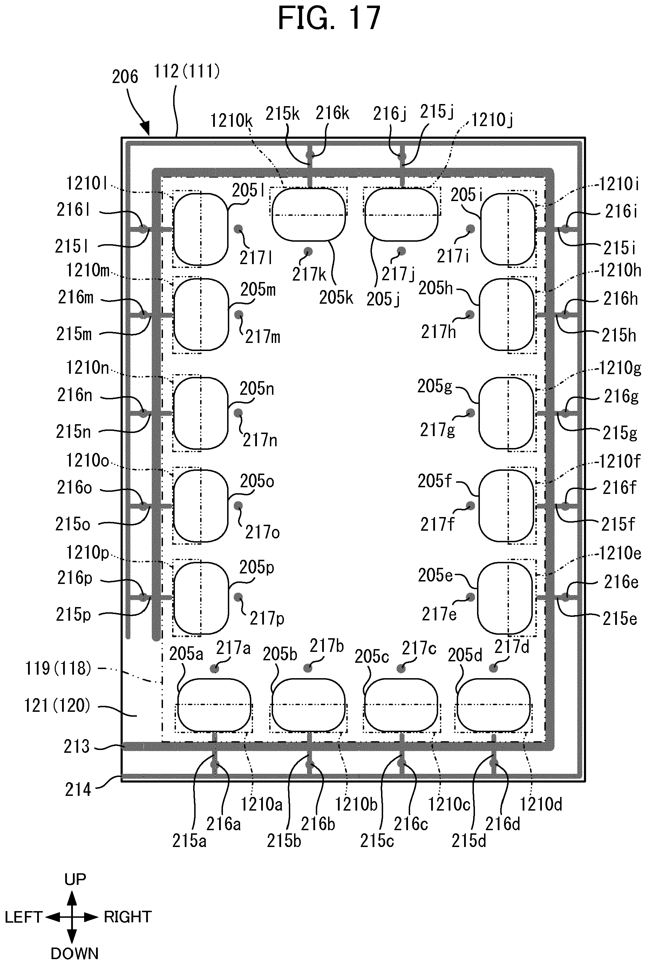

As illustrated in FIG. 17, which is a front view of the touch panel 206 of the present example, a difference between a touch panel 206 according to the present example and the touch panel 106 according to Example 1 lies in the ranges in which the first conductive path 213, the second conductive path 214, the pressure-detecting conductive paths 215a to 215p, and the structures 205a to 205p are disposed.

Specifically, as illustrated in the drawing, the first conductive path 213 and the second conductive path 214 are disposed to surround the image transmission regions 118 and 119, that is, are disposed substantially along the entire outer edges of the image transmission regions 118 and 119. The pressure-detecting conductive paths 215a to 215p are spaced substantially evenly in directions parallel to the respective four sides of the outer edges of the image transmission regions 118 and 119. As illustrated in the drawing, the structures 205a to 205p, spacers 216a to 216p and 217a to 217p are disposed in association with the pressure-detecting conductive paths 215a to 215p. The other components of the touch panel 206 are similar to those of the touch panel 106 according to Example 1. That is, the minimum pressure-sensitive regions 1210a to 1210p are, as viewed from the front, defined between the first conductive path 213 and each of the regions in which the spacers 217a to 217p are arranged.

In the state in which the structures 205a to 205p are not pressed, in the minimum pressure-sensitive regions 1210a to 1210p, the spacers 217a to 217p enable the maintenance of a gap between the second sheet 112 and the first sheet 111 that oppose each other in the front-back direction. Then when any of the structures 205a to 205p is pressed, the gap in between the first sheet 111 and the second sheet 112 at the minimum pressure-sensitive region 1210a to 1210p corresponding to the pressed structure 205a to 205p becomes narrower. As a result of such narrowing, the pressure-detecting conductive path 215a to 215p corresponding to the pressed structure 205a to 205p can be made to reliably flex together with the second sheet 112 so as to enable electrical contact with the first conductive path 213.

In the present example, the first conductive path 213 and the second conductive path 214 are disposed to surround the image transmission regions 118 and 119. Thus as illustrated in FIG. 16, the structures 205a to 205p can be arranged along the outer edge of the image transmission regions 118 and 119. Such configuration enables the arrangement of a larger number of structures 205a to 205p in comparison to the touch panel 106 in Example 1.

### Example 3

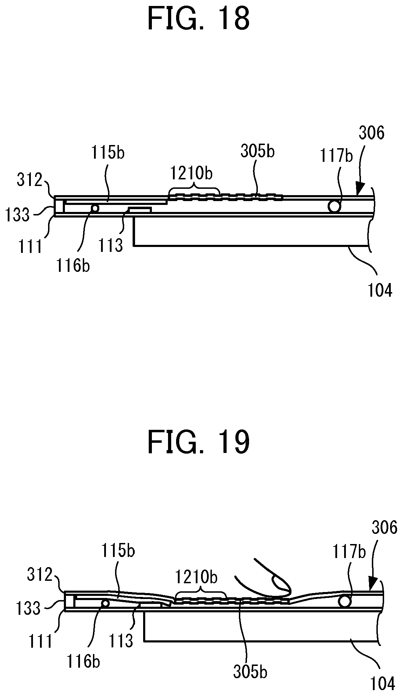

As illustrated in FIG. 18, which is a cross-sectional view, a portion of the touch panel 306 according to the present example, corresponding to the structures 105a to 105i of Example 1, is different from that of the touch panel 106 according to Example 1 in that the portion has, instead of the structures, surface processed parts 305a to 305i where the surface of the second sheet 312 is processed to increase stiffness and/or hardness. FIG. 19 illustrates a surface-processed part 305b as an example.

Specifically, the surface-processed parts 305a to 305i are parts where an effect is obtained, similar to that of the structures 105a to 105i, by using creasing, embossing, and the like to increase stiffness and/or hardness in comparison to the surface of the second sheet 312 at the unprocessed part.

In Example 3, for example, as illustrated in the cross-sectional view of FIG. 19, when the surface-processed part 305b is pressed, due to high hardness or stiffness of the surface-processed part 305b, the surface-processed part 305b uniformly sinks downward even when the edge of the surface-processed part 305b is pressed. Thus the minimum pressure-sensitive region 1210b is pressed, and due to flexing of the second sheet 312 in the periphery of the pressed portion, the pressure-detecting conductive path 115b and the first conductive path 113 are electrically connected. That is, electrical connection is made between the first conductive path 113 and the pressure-detecting conductive path 115b associated with the pressed surface-processed part 305b.

In this manner, the touch panel 306 outputs a signal that corresponds to the pressed surface-processed part 305a to 305i. The remaining configuration of the touch panel 306 is similar to that of the touch panel 106 according to Example 1. The present sample enables the obtaining of an effect similar to that of the touch panel 106 of Example 1 while using fewer components.

### Example 4

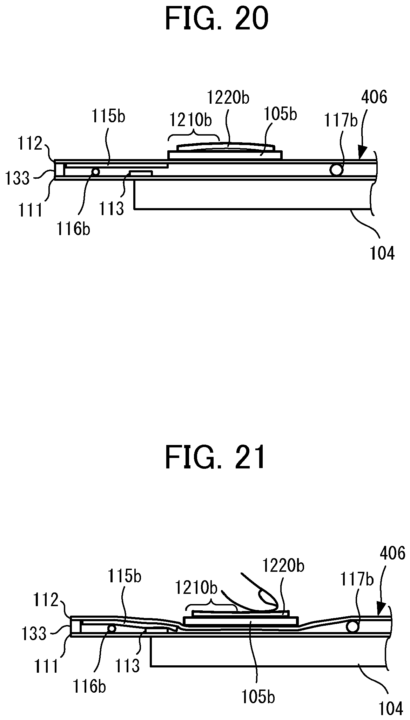

As illustrated in FIG. 20, which is a cross-sectional view, tactile parts 1220a to 1220i in a touch panel 406 according to the present example are disposed so as to be stacked upon the structures 105a to 105i. FIG. 20 illustrates the tactile part 1220b as an example. That is, as viewed in the normal direction of the first sheet 111, the tactile parts 1220a to 1220i can be disposed in a range that is a portion of, or is greater than or equal to, the entirety of the structures 105a to 105i. The tactile parts 1220a to 1220i are components characterized as being made of a material that is different from that of the structures 105a to 105i, and the structures 105a to 105i can be operated through a touch panel 406 without being directly touched.

Further, the user during operation of the touch panel 406, due to the substance or configuration of the tactile part 1220a to 1220i, can be given a different feel when the structure 105a to 105i is pressed that differs. For example, in a case such as illustrated in the cross-sectional view of FIG. 21 in which the tactile part 1220b is made of a substance such as a rubber or an elastic resin, the user feels softness when pressing the tactile part 1220b, and the structure 105b is also pressed down by the tactile part 1220b. Due to the high hardness or stiffness of the structure 105b, the structure 105b sinks downward uniformly, the minimum pressure-sensitive region 1210b is also pressed, and due to flexing of the second sheet 112 in the periphery of the pressed portion, the pressure-detecting conductive path 115b and the first conductive path 113 are electrically connected.

In this manner, the touch panel 406 outputs a signal in accordance with the pressed tactile part 1220a to 1220i (structure 105a to 105i). The remaining configuration of the touch panel 406 is similar to that of the touch panel 106 according to Example 1.

The user in the present example operates the touch panel 406 by pressing the tactile parts 1220a to 1220i, and thus a soft feel can be imparted to the user in comparison to the direct pressing of the structures 105a to 105i as in the touch panel 106 according to Example 1.

### Example 5

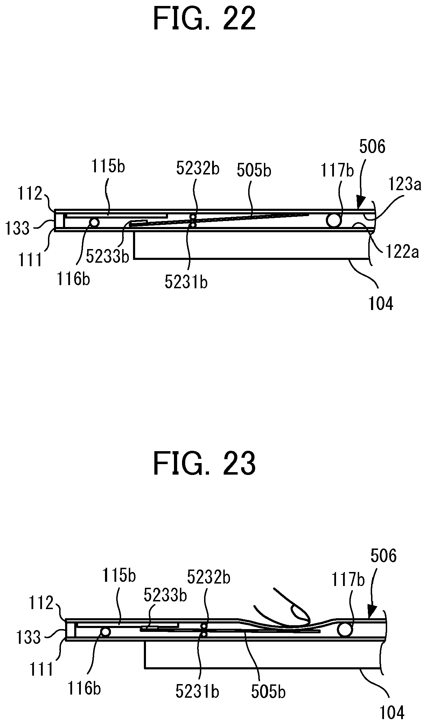

As illustrated in the cross-sectional view of FIG 22, in the touch panel 506 according to the present example, structures 505a to 505i with the substrate-mounted contact points 5233a to 5233i are also disposed between the first main surface 122a of the first sheet 111 and the second main surface 123a of the second sheet 112 of the touch panel 506. Further, FIG. 22 illustrates the structure 505b as an example. That is, the substrate-mounted contact point 5233b is formed at an end portion of the structure 505b, is sandwiched between a paste stacked layer 5231b and a spacer 5232b, and is disposed between the first sheet 111 and the second sheet 112. In the same manner, the structures 505a and 505c to 505i with the substrate-mounted contacts points 5233a and 5233c to 5233i are also disposed between the first sheet 111 and the second sheet 112.

In the present example, as illustrated in the cross-sectional view of FIG. 23, when the user presses the position at which the structure 505b is disposed in the normal direction of the touch panel 506, the structure 505b, that is, a left side thereof as seen in the drawing, rises by pivoting around a fulcrum point of the paste stacked layer 5231b and the spacer 5232b, and the substrate-mounted contact point 5233b contacts the pressure-detecting conductive path 115b. At this time, the touch panel 506 functions as a switch due to a change in electrical characteristics of the touch panel 506.

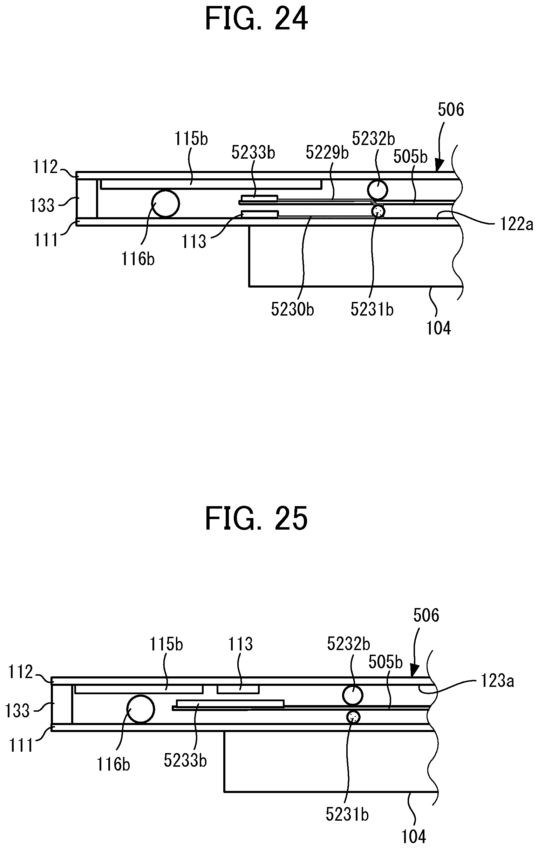

Further, electrical connection may be made between the first sheet 111 and the second sheet 112. Specifically, as illustrated in the cross-sectional view of FIG. 24, in the touch panel 506, structures 505a to 505i that include wires 5229a to 5229i and substrate-mounted contact points 5233a to 5233i are disposed between the first sheet 111 and the second sheet 112. These wires 5229a to 5229i are wires that electrically connect between the substrate-mounted contact points 5233a to 5233i and the paste stacked layers 5231a to 5231i. Further, the paste stacked layers 5231a to 5231i are formed from an electrically conductive material. Wires 5230a to 5230i are formed on the first main surface 122a of the first sheet 111 and connect together the first conductive path 113 and the paste stacked layers 5231a to 5231i. FIG. 24 illustrates the structure 505b as an example. That is, the substrate-mounted contact point 5233b formed on the structure 505b and the first conductive path 113 are connected together electrically via the wire 5229b, the paste stacked layer 5231b, and the wire 5230b. In the same manner, the substrate-mounted contact points 5233a and 5233c to 5233i formed on the structures 505a and 505c to 505i and the first conductive path 113 are connected together electrically via the wires 5229a and 5229c to 5229i, the paste stacked layers 5231a and 5231c to 5231i, and the wires 5230a and 5230c to 5230i.

In this case, when the user presses the position at which the structure 505b is disposed in the normal direction of the touch panel 506, the structure 505b, that is, the left side thereof as seen in the drawing, rises by pivoting around a fulcrum point of the paste stacked layer 5231b and the spacer 5232b, and the substrate-mounted contact point 5233b contacts the pressure-detecting conductive path 115b. That is, electrical contact is made between the first conductive path 113 and the pressure-detecting conductive path 115b associated with the pressed structure 505b.

Although FIG. 24 illustrates an example in which the paste stacked layer 5231b and the spacer 5232b are disposed within the image transmission regions 118 and 119 of the touch panel 506, these components may be disposed outside of the image transmission regions 118 and 119, that is, may be disposed within the surrounding areas 120 and 121. In this case, the wire 5229a and the wire 5230b are disposed within the surrounding area 120 and 121, and thus such configuration enables obtaining of visual unrecognizability of the wire 5229a and the wire 5230b for the user.

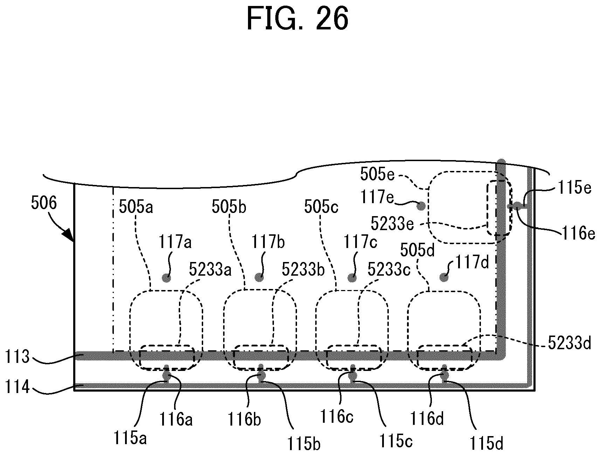

As illustrated in the cross-sectional view of FIG. 25 and the front view of FIG. 26, according to the present invention, a configuration is adopted in which the first conductive path 113 is formed on the second main surface 123a of the second sheet 112 of the touch panel 506, and the pressure-detecting conductive path 115a to 115i and the first conductive path 113 are made to contact each other electrically via the substrate-mounted contact points 5233a to 5233i formed on the structures 505a to 505i. FIG. 25 illustrates the structure 505b as an example.

Then when the user presses the position where the structure 505b is disposed in the normal direction of the touch panel 506, the structure 505b, that is, the left side as see in FIG. 25, rises by pivoting around the fulcrum point of the paste stacked layer 5231b and the spacer 5232b, and the substrate-mounted contact point 5233b contacts the pressure-detecting conductive path 115b and the first conductive path 113. That is, electrical contact is made between the first conductive path 113 and the pressure-detecting conductive path 115b associated with the pressed structure 505b. In this case, the wire 5229b and the wire 5230b as illustrated in FIG. 24, that is, the wires 5229a to 5229i and the wires 5230a to 5230i, become unnecessary, thereby enabling a further lowering of cost.

### Industrial Applicability

The present disclosure can be used for a touch panel used for various types electrical equipment, devices, and the like.

### Reference Signs List

100 Remote controller
101 Communication line
102 Air conditioner
103 Cover
104 Display
105a to 105i, 205a to 205p, 305a to 305i, 505a to 505i Structure
106, 206, 306, 406, 506 Touch panel
107 Power supply button
108 Power supply
109 Microcomputer
110 Opening
111 First sheet
112 Second sheet
113 First conductive path
114 Second conductive path
115a to 115i Pressure-detecting conductive path
116a to 116i, 117a to 117i, 216a to 216p, 217a to 217p, 5232a to 5232i Spacer
118, 119 Image transmission region
120, 121 Surrounding area
122a First main surface
123a Second main surface
122b Third main surface
123b Fourth main surface
124 A/D input port
125 Resistor
126 Control content data
127 Control content storage
128 Input signal controller
129 Device controller
130 Display controller
131 Input device
133 Adhesive
1210a to 1210p Minimum pressure-sensitive region
1220a to 1220i Tactile part
5229a to 5229i, 5230a to 5230i Wire
5231a to 5231i Paste stacked layer
5233a to 5233i Substrate-mounted contact point

## Claims

1. A touch panel comprising:
a first sheet (111);
a second sheet (112), the first sheet (111) and the second sheet (112) opposing each other with a gap therebetween;
a main conductive path (113) formed on an inner surface of the second sheet (112);
a supplementary conductive path (115a-115i) formed on the inner surface of the second sheet (112) and spaced apart from the main conductive path (113) as viewed in a normal direction of the first sheet (111); and
a structure (545a-505i) disposed between the first sheet (111) and the second sheet (112) and configured to form a contact point (5233a-5233i), the contact point (5233a-5233i) overlapping the main conductive path (113) and the supplementary conductive path (115a-115i) as viewed in the normal direction,
**characterized in that**
the structure (505a-505i) is supported by a supporting member (5231a-5231i, 5232a-5232i) in a state in which the contact point (5233a-5233i) is not in contact with either the main conductive path (113) or the supplementary conductive path (115a-115i), and
upon downward pressing of an edge of the structure (505a-505i) through the second sheet (112), the structure (505a-505i) pivots using the supporting member (5231a-5231i, 5232a-5232i) as a fulcrum point to cause the contact point (5233a-5233i) to contact the main conductive path (113) and the supplementary conductive path (115a-115i).

2. The touch panel according to claim 1, wherein the structure (505a-505i) is harder or stiffer than the second sheet (112).

## Patentansprüche

1. Berührungsfeld, umfassend:
eine erste Platte (111);
eine zweite Platte (112), wobei sich die erste Platte (111) und die zweite Platte (112) mit einer Lücke dazwischen gegenüberliegen;
eine Hauptleiterbahn (113), die auf einer inneren Oberfläche der zweiten Platte (112) ausgebildet ist;
eine Nebenleiterbahn (115a-115i), die auf der inneren Oberfläche der zweiten Platte (112) ausgebildet ist und von der Hauptleiterbahn (113), betrachtet in einer Normalrichtung der ersten Platte (111), beabstandet ist; und
eine Struktur (505a-505i), die zwischen der ersten Platte (111) und der zweiten Platte (112) angeordnet ist und eingerichtet ist, einen Kontaktpunkt (5233a-5233i) zu bilden, wobei der Kontaktpunkt (5233a-5233i) die Hauptleiterbahn (113) und die Nebenleiterbahn (115a-115i), betrachtet in der Normalrichtung, überlappt,
**dadurch gekennzeichnet, dass**
die Struktur (505a-505i) durch ein Stützelement (5231a-5231i, 5232a-5232i) in einem Zustand gestützt wird, in dem der Kontaktpunkt (5233a-5233i) mit keiner von der Hauptleiterbahn (113) und der Nebenleiterbahn (115a-115i) in Kontakt ist, und
beim Herunterdrücken einer Kante der Struktur (505a-505i) durch die zweite Platte (112) die Struktur (505a-505i) unter Verwendung des Stützelements (5231a-5231i, 5232a-5232i) als einen Drehpunkt schwenkt, um zu bewirken, dass der Kontaktpunkt (5233a-5233i) die Hauptleiterbahn (113) und die Nebenleiterbahn (115a-115i) kontaktiert.

2. Berührungsfeld gemäß Anspruch 1,
wobei die Struktur (505a-505i) härter oder steifer ist als die zweite Platte (112).

## Revendications

1. Panneau tactile comprenant :
une première plaque (111) ;
une seconde plaque (112), la première plaque (111) et la seconde plaque (112) étant opposées l'une à l'autre avec un espace entre elles ;
un trajet conducteur principal (113) formé sur une surface interne de la seconde plaque (112) ;
un trajet conducteur supplémentaire (115a-115i) formé sur la surface interne de la seconde plaque (112) et espacé du trajet conducteur principal (113) lorsque l'on regarde dans une direction normale de la première plaque (111) ; et
une structure (505a-505i) disposée entre la première plaque (111) et la seconde plaque (112) et configurée pour former un point de contact (5233a-5233i), le point de contact (5233a-5233i) chevauchant le trajet conducteur principal (113) et le trajet conducteur supplémentaire (115a-115i) lorsque l'on regarde dans la direction normale,
**caractérisé en ce que**
la structure (505a-505i) est supportée par un élément de support (5231a-5231i, 5232a-5232i) dans un état dans lequel le point de contact (5233a-5233i) n'est pas en contact avec le trajet conducteur principal (113) ou le trajet conducteur supplémentaire (115a-115i), et
lorsque l'on appuie sur un bord de la structure (505a-505i) à travers la seconde plaque (112), la structure (505a-505i) pivote en utilisant l'élément de support (5231a-5231i, 5232a-5232i) comme point de pivotement afin que le point de contact (5233a-5233i) touche le trajet conducteur principal (113) et le trajet conducteur supplémentaire (115a-115i).

2. Panneau tactile selon la revendication 1, dans lequel la structure (505a-505i) est plus dure ou plus rigide que la seconde plaque (112).
